# EUROPÄISCHE PATENTSCHRIFT

(11) **EP 2 855 567 B1**
(45) Veröffentlichungstag und Bekanntmachung des Hinweises auf die Patenterteilung: **04.08.2021**
(21) Anmeldenummer: 13747785.7
(22) Anmeldetag: 30.05.2013
(51) Int. Cl.: B05D 7/02, B05D 7/00, C23C 14/00, C08J 7/044, C23C 14/20, C08J 7/04, C23C 14/58

(54) **IN LACKSCHICHTEN EINGEBETTETE PVD-SCHICHTEN**
PVD COATINGS EMBEDDED IN COATS OF PAINT
REVÊTEMENTS PVD INTÉGRÉS À DES COUCHES DE VERNIS

(30) Priorität: 30.05.2012 US 201261653058 P
(43) Veröffentlichungstag der Anmeldung: 08.04.2015
(73) Patentinhaber: Oerlikon Surface Solutions AG, Pfäffikon, 8808 Pfäffikon, SZ (CH)
(72) Erfinder: KECKES, Antal, 78244 Gottmadingen (DE); HERMANN, Thomas, 72510 Stetten am kalten Markt (DE); SCHULER, Peter, 72202 Nagold (DE); SCHAEFER, Ruediger, 79865 Grafenhausen (DE); BAUER, Sascha, 88605 Messkirch (DE)
(74) Vertreter: Kempkens, Anke
(86) Internationale Anmeldenummer: PCT/EP2013/001595
(87) Internationale Veröffentlichungsnummer: WO 2013/178363

(56) Entgegenhaltungen:
- EP-A1- 1 484 428
- WO-A2-2010/127866
- DE-A1- 10 337 456
- DE-A1-102010 019 913
- US-A1- 2002 172 843
- US-A1- 2007 020 369
- US-A1- 2007 154 693
- US-B1- 6 168 242
- US-B1- 7 132 130
- None

## Beschreibung

Die vorliegende Erfindung bezieht sich auf ein auf Kunststoffsubstrate aufgebrachtes Schichtsystem. Dieses Schichtsystem umfasst eine mittels Abscheidung aus der Gasphase erzielte Schicht (PVD-Schicht) welche zwischen zwei Lackschichten (beispielweise unten eine Basecoat und oben eine Topcoat) eingebettet ist. Ein solches System wird im Folgenden Coating-System genannt. Erfindungsgemäss umfasst die aus der Gasphase abgeschiedene Schicht mehrere, d.h. zumindest zwei Lagen und ist vorzugsweise ein Wechselschichtsystem. Vorzugsweise haben zumindest zwei dieser Lagen eine unterschiedliche Zusammensetzung. Vorzugsweise handelt es sich dabei um eine mehrere Lagen umfassende PVD-Schicht (PVD ist die Abkürzung des englischen Begriffs "physical vapor deposition", der in Deutsch als "physikalische Gasphasenabscheidung" oder "physikalische Abscheidung aus der Gasphase" übersetzt wird).

Aus DE 10 2010 019913 A1 (Grohe I), WO 2010/127866 A2 (Grohe II), DE 103 37 456 A1 (Hartec), US 2007/154693 A1 (Tsai), US 7 132 130 B1 (Kloss), US 6 168 242 B1 (Mokerji I), US 2002/172843 A1 (Mokerji II) und EP 1 484 428 A1 (Maxford) ist es beispielsweise bekannt einen Kunsstoffbauteil mit metallischem Glanz zu versehen, insbesondere, auf einem Kunststoffbauteil, wenigstens zwischen einer Basislackschicht und Toplackschicht, Beschichtungen mittels PVD herzustellen, wobei Grohe I, II und Hartec semi-transparente metallische Beschichtungen offenbaren. Ausserdem beschreibt Grohe II das Auftragen von mehreren dünnen metallischen Schichten auf Kunststoffsubstrate, wie zum Beispiel AcrylnitrilButadien-Styrol (ABS), um weitere Eigenschaftsvorteile zu dekorativen Zwecken zu erreichen. Solche Substrate können beispielsweise hinterleuchtet werden, um Symbole darzustellen. Kloss und Maxford hingegen offenbaren PVD Chrom- und Aluminium-Schichten oder Schichten aus Aluminium-Legierungen, die nachträglich anodisch oxidiert werden können.

Das Coating-System gemäss der vorliegenden Erfindung kann als Lösung für verschiedene Probleme verwendet werden. Ein solches Schichtsystem ist nicht nur im Hinblick auf dekorative Beschichtungen interessant, sondern eröffnet in der Anwendung von Kunststoffkomponenten viele Möglichkeiten.

Einige dieser Anwendungsmöglichkeiten werden nun im Folgenden kurz beispielhaft skizziert. Es handelt sich teilweise um Beispiele aus dem Stand der Technik, die das Verständnis der Erfindung erleichtern. Hingegen ist das Ausführungsbeispiel 7 Teil der Erfindung.

### Beispiel 1 (Stand der Technik):

### Bezug auf:

### Fussgängerschutz - Aufprallschutz

Gewünscht ist es ein flaches Substrat zur Verfügung zu haben, das optisch metallisch aber gleichzeitig flexibel und bruchfest und in Form an Bauteil anpassbar ist.

Gemäss dem Stand der Technik wird diese Aufgabe mit Hilfe der Folientechnik oder der Galvanik gelöst, jedoch ist die Folientechnik sehr teuer und die Galvanik bringt mit sich den Nachteil, dass scharfe Kanten produziert werden.

Erfindungsgemäss wird das Problem dadurch gelöst, dass das Coating-System auf flexiblen kostengünstigen Kunststoffsubstraten oder Kunststoffbauteilen beispielweise aus PP und/oder ABS aufgebracht wird. Dadurch bleibt das Kunststoffsubstrat bzw. das Kunststoffbauteil flexibel und bruchfest aber wird optisch metallisch. Mit Hilfe der oben genannten PVD und Lacken-Technologie kann das Coating-System auf Substraten bzw. Bauteile mit verschiedenen Formen und Dimensionen einfach appliziert werden.

### Beispiel 2 (Stand der Technik):

### Bezug auf:

### Halbdurchlässige/Translux für ambiente Beleuchtung und metallisch glänzend ohne Hinterleuchtung in Hochglanz und Seidenglanz

### bisherige Technik:

### Folientechnik und Silberlack

Problemlösung gemäss der vorliegenden Erfindung:
Coating-System auf transparenten Substraten z.B. PC, PMMA

### Beispiel 3 (Stand der Technik):

### Bezug auf:

### Bauteile mit hinterleuchteten Symbolen

### bisherige Technik:

### Lacke, Folientechnik und Galvanik (BIA Patent)

Problemlösung gemäss der vorliegenden Erfindung:
Coating-System auf semi-/transparenten Substraten z.B. PC, PMMA mit Laserung PVD Schicht

### Beispiel 4 (Stand der Technik):

### Bezug auf:

### Gewichtsersparnis und Resourcenschonung (kein Cu und Ni)

### bisherige Technik:

### Galvanik

Problemlösung gemäss der vorliegenden Erfindung:
Coating-System mit ca. 90% Gewichtsersparnis im vgl. zur Galvanikschicht

### Beispiel 5 (Stand der Technik):

### Bezug auf:

### Überlackierbarkeit von UV Lacken

### bisherige Technik:

### Fluorieren, Reaktivplasma, Atmosphärenplasma

Problemlösung gemäss der vorliegenden Erfindung:
UV Oberflächen Aktivierung mit Magnetron Sputtern und Reaktivplasma

### Beispiel 6 (Stand der Technik):

### Bezug auf:

### Strukturierte Oberflächen hervorheben mit PVD (Direktmetallisierung)

KS-Struktur kann im Werkzeug eingebracht werden oder über Ätzprozesse, Laserung Struktur kann für easy to clean Prozesse oder optische Wirkung erzeugt werden

### bisherige Technik:

### dicke Schichten decken Strukturen ab

Problemlösung gemäss der vorliegenden Erfindung:
PVD Direktmetallisierung mit Decklack (Glanz, Seidenglanz)

### Beispiel 7:

### Bezug auf:

### Herstellung von Farbschichten auf Kunstoffoberflächen

### Bisherige Technik:

Erstellen von Interferenzfarben durch die Erzeugung von transparenten Schichten mit Hilfe der PVD-Technologie auf die Kunststoffoberflächen, z.B. durch die Verwendung von Kathodenzerstäubungstechnologien (z.B. Magnetron Sputtering). Solche Schichten müssen in der Regel eine genaue Schichtdicke aufweisen, um eine gewisse Farbe zu reflektieren.

Deswegen ist es sehr schwierig durch die Verwendung dieser Technik eine gleichmässige Farbe auf nicht ebene Oberflächen zu erreichen.

Problemlösung gemäss der vorliegenden Erfindung:
Die Farbschichten werden durch anodische Oxidation von Ti/Al Schichten, die zuvor mit PVD-Techniken abgeschieden wurden. Vorzugsweise, wird gemäss der vorliegenden Erfindung zuerst zumindest eine Lackschicht als Basecoat auf die Substratoberfläche appliziert, danach wird die zumindest zweilagige PVD-Schicht (beispielweise aus Titan und Aluminium) abgeschieden, anschliessend wird die bisher so beschichtete Oberfläche einem anodischen Oxidationsprozess unterzogen und abschliessend wird zumindest noch eine Lackschicht als Topcoat appliziert.

### Beispiel 8 (Stand der Technik):

### Bezug auf:

### Abscheidung von spannungsarmen PVD-Schichten

### Bisherige Technik:

Häufig weisen PVD-abgeschiedene Schichten hohe Eigenspannungen auf, die zu Brüchen oder Rissen innerhalb der Schicht führen.

Problemlösung gemäss der vorliegenden Erfindung:
Spezielle Prozessführung zur Reduzierung der Eigenspannungen innerhalb der PVD-Schicht. Das kann beispielsweise dadurch erreicht werden in dem man zuerst die erste Lackschicht (Basecoat) derart appliziert, dass die Lackschichteigenschaften (beispielweise Härte und/oder E-Modul und/oder Dicke) die Erzeugung von Eigenspannungen bei der nachträglichen Abscheidung der PVD-Schicht derart beeinflusst, dass die Eigenspannungen innerhalb der PVD-Schicht geringer werden.

### Beispiel 9 (Stand der Technik):

### Bezug auf:

### Erzeugung von schwarzen Kunststoffoberflächen mit metallischem Aussehen

### Bisherige Technik:

Die Oberflächen werden schwarz metallisiert, was zur Erzeugung einer gewissen Leitfähigkeit der Oberfläche führt, die für manche Anwendungen unerwünscht oder unzulässig ist.

Problemlösung gemäss der vorliegenden Erfindung:
Die bereits schwarze Kunststoffoberfläche bzw. Oberfläche eines schwarzen Kunststoffbauteils wird mit einer transparenten Metalloxidschicht beschichtet, wodurch aufgrund optischer Effekte ein metallisches Aussehen entsteht.

Nichtleitende Metalloxidschichten, die transparent sind, erreichen ein metallisches Aussehen mit der richtigen Kombination aus Schichtdicke und schwarzem Hintergrund.

Vorzugsweise kann auf das schwarze Kunststoffsubstrat zuerst eine Basecoat appliziert, anschliessend eine zumindest zweilagige PVD-Schicht aus einem oder mehreren transparenten, elektrisch nichtleitenden Metalloxiden abgeschieden und abschliessend eine Topcoat.

### Beispiel 10 (Stand der Technik):

### Bezug auf:

### Erzeugung von Oberflächen von Kunststoffbauteilen, die als elektrischer Leiter oder Kondensator funktionieren können.

### Problematik mit der bisherigen Technik:

### Flexibilität und Grösse

Problemlösung gemäss der vorliegenden Erfindung:
Elektrischer Leiter: Auftragung eines elektrisch leitenden Überzugs, beispielweise durch die Abscheidung einer metallischen, elektrisch leitenden PVD-Schicht. Ein Problem steht da aber, wenn die elektrisch leitfähige PVD-Schicht abplatzt, weil dann die elektrische Leitfähigkeit unterbrochen ist.

Eine weitere Variante, die zur Herstellung von Kondensatoren verwendet könnte ist eine mehrlagige Schichtsystem ... PVD-Schicht/Lack/PVD-Schicht/Lack/PVD-Schicht/Lack... Vorzugsweise kann man beispielweise das Konzept Coating-System gemäss der vorliegenden Erfindung: Basecoat + mehrlagige (zumindest zweilagige) PVD-Schicht + Topcoat direkt auf ein Kunststoffsubstrat abscheiden um kapazitive Eigenschaften zu erreichen.

### Beispiel 11 (Stand der Technik):

### Bezug auf:

### Kennzeichnung in der Natur

Problematik mit den bisherigen Techniken:
Schadstoffe in der Natur

Problemlösung gemäss der vorliegenden Erfindung: Kombination Lacke + PVD gemäss der vorliegenden Erfindung. PVD verursacht keine grosse Umweltbelastung.

### Beispiel 12 (Stand der Technik):

### Bezug auf:

### Spiegel, Hochreflexion.

Problematik mit den bisherigen Techniken:
Gewicht, Flexibilität

Problemlösung gemäss der vorliegenden Erfindung:
Erzeugung von Spiegel- bzw. Hochreflexionseigenschaften durch die Auftragung eines Coating-System gemäss der vorliegenden Erfindung.

### Beispiel 13 (Stand der Technik):

### Bezug auf:

### Leistensysteme

Problematik mit den bisherigen Techniken:
hohe Werkzeugkosten für L-förmige Leisten - schweres Handling

Problemlösung gemäss der vorliegenden Erfindung:
Beschichtung (Auftragung eines Coating-System gemäss der vorliegenden Erfindung) einer geraden Leiste, welche später umgeformt wird. Auch möglich für Embleme im Heck.

Die direkte Überlackierung von Topcoat auf Basecoat ist nicht möglich aber durch das Konzept Coating-System gemäss der vorliegenden Erfindung: Basecoat + mehrlagige (zumindest zweilagige) PVD-Schicht + Topcoat
wird eine deutlich bessere Lackierbarkeit ermöglicht.

## Patentansprüche

1. Kunststoffbauteil mit Beschichtung, wobei die Beschichtung aus einem Schichtsystem besteht, welches eine auf der Kunststoffoberfläche aufgebrachte Basislackschicht umfasst, auf der eine mittels Abscheiden aus der Gasphase aufgebrachte Schicht bzw. PVD-Schicht vorgesehen ist, die ihrerseits von einer Toplackschicht bedeckt ist, wobei, dass die aus der Gasphase abgeschiedene aufgebrachte Schicht mehrere Lagen umfasst, **dadurch gekennzeichnet, dass**
• das Bauteil durch die Beschichtung eine neue Farbe der Kunststoffoberfläche aufweist und die PVD-Schicht zumindest eine zweilagige Ti/Al Schicht aus Titan und Aluminium umfasst, welche anodisch oxidiert ist.

2. Verfahren zur Herstellung eines Kunststoffbauteils mit einer neuen Farbe der Kunststoffoberfläche gemäss dem Anspruch 1, wobei zuerst zumindest eine Lackschicht als Basislackschicht auf die Kunststoffoberfläche appliziert wird, danach die zumindest zweilagige Ti/Al PVD-Schicht aus Titan und Aluminium abgeschieden wird, anschliessend die bisher so beschichtete Oberfläche einem anodischen Oxidationsprozess unterzogen wird, und abschliessend zumindest noch eine Lackschicht als Toplackschicht appliziert wird.

## Claims

1. A plastic component with a coating, wherein the coating consists of a layer system that comprises a basic lacquer layer applied to the plastic surface, on which basic lacquer layer a layer or a PVD layer applied by means of deposition from the gas phase is provided, which in turn is covered by a top lacquer layer, wherein the applied layer that is deposited from the gas phase comprises several layers, **characterized in that**
• due to the coating the component has a new color of the plastic surface and the PVD layer comprises at least a two-layer Ti/Al coating consisting of titanium and aluminum and oxidizing anodically.

2. A method for producing a plastic component with a new color of the plastic surface according to claim 1, wherein, first, at least one lacquer layer is applied to the plastic surface as a basic lacquer layer, then the at least two-layer Ti/Al - PVD coating made of titanium and aluminum is deposited, then the surface that has been coated in this way is subjected to an anodic oxidation process, and finally at least one lacquer layer is applied as a top lacquer layer.

## Revendications

1. Composant en matière plastique ayant un revêtement, le revêtement consistant en un système de couches qui comprend une couche de vernis de base appliquée sur la surface en matière plastique, une couche ou une couche PVD appliquée au moyen d'un dépôt à partir de la phase gazeuse étant prévue sur la couche de vernis de base, ladite couche ou couche PVD à son tour étant recouverte d'une couche de vernis supérieure, la couche appliquée qui est déposée à partir de la phase gazeuse comprenant plusieurs couches, **caractérisée en ce que**
• par le revêtement, le composant a une nouvelle couleur de la surface en matière plastique et la couche PVD comprend un revêtement Ti/AI à au moins deux couches qui consiste en titane et aluminium et oxyde de manière anodique.

2. Procédé de fabrication d'un composant en matière plastique avec une nouvelle couleur de la surface en matière plastique selon la revendication 1, tout d'abord, au moins une couche de laque étant appliquée sur la surface en matière plastique en tant que couche de vernis de base, puis le revêtement PVD de Ti/AI à au moins deux couches consistant en titane et aluminium étant déposé, puis la surface préalablement revêtue étant soumise à un processus d'oxydation anodique , et enfin au moins une couche de vernis étant appliquée en tant que couche de vernis supérieure.
